# EUROPEAN PATENT APPLICATION

(11) **EP 1 515 433 A1**
(43) Date of publication of application: **16.03.2005**
(21) Application number: 04255105.1
(22) Date of filing: 25.08.2004
(51) Int. Cl.: H03F 3/45

(54) **Controlled offset amplifier**

(30) Priority: 05.09.2003 US 656087
(71) Applicant: Monolithic Power Systems, Inc., Los Gatos, CA 95032 (US)
(72) Inventor: Moyer, James Copland, San Jose California 98129 (US)
(74) Representative: Hackney, Nigel John

(57) **Abstract**

A controlled offset amplifier comprises an input stage including two transistors. The two transistors have different threshold voltage implants. The amplifier also includes an amplification stage that receives a signal from the input stage and provides an output signal related to the signal.

## Description

The present invention relates to amplifiers, and more particularly, to an amplifier that has a controlled offset between the input and output.

Amplifiers are used in nearly every integrated circuit. They can be used to accurately control the amplification of an input signal to a predetermined level, either in an inverting or non-inverting manner. They may also be used to amplify the difference of two input signals. As another example, they may be used to differentiate or integrate an input signal. In still other applications, the amplifier may merely be used as a buffer or driver wherein the output signal is the same as, or offset by a predetermined amount from, the input voltage.

In one application, an amplifier may be used in an inverter for driving a discharge lamp, such as a cold cathode fluorescent lamp (CCFL). The inverter converts a DC signal to an AC signal, filters the AC signal, and transforms the voltage to the higher voltages required by a CCFL. Examples of such inverters are shown in U.S. Patent No. 6,114,614 to Shannon et al., assigned to the assignee of the present invention and herein incorporated by reference in its entirety. Also, the MP1011, MP1012, and MP1022 products from Monolithic Power Systems, Inc. are exemplary of the type of inverter used to drive a CCFL.

In the inverter application and others, it is desirable to precisely control the voltage offset between the output and input attributable to the amplifier.

In various aspects, the present invention provides a controlled offset amplifier according to claim 1 and a method according to claim 6.

### Brief Description of the Drawings

The foregoing aspects and many of the attendant advantages of this invention will become more readily appreciated as the same becomes better understood by reference to the following detailed description, when taken in conjunction with the accompanying drawings, wherein:

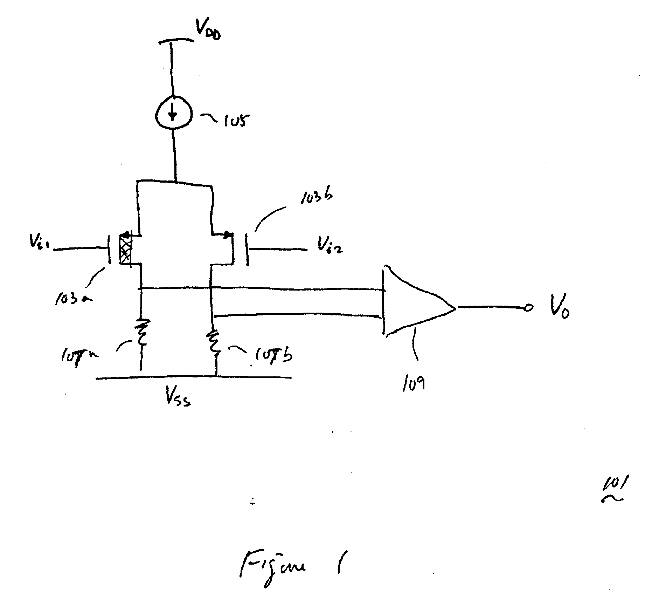

FIGURE 1 is a schematic diagram of an amplifier formed in accordance with one embodiment of the present invention.

### Detailed Description of the Invention

What is disclosed is a circuit and process technique that allows a plurality of amplifiers and/or comparators to equally level-shift between one side and the other of a differential input. In other words, the amplifier should be able to shift the level of the input signal by a predetermined amount. The effect is a benefit when either the input or output uses a supply rail (such as ground) as a reference and the other side must be driven above and below the reference.

Level-shifting may be accomplished in the prior art simply by using a bank of matched transistors in source follower configuration to buffer one set of inputs. Most followers, such as MOS source followers or bipolar emitter followers, have a predictable offset from input to output. For example, a PMOS source follower output is exactly V_{gs} more positive than its input voltage.

For transistor geometries used in high voltage applications, such as an inverter for a CCFL, V_{gs} for a PMOS source follower would be about 1.5 to 2 volts depending on how the follower was biased. One disadvantage of this technique is that all the source followers buffering a set of amplifiers and comparators would have to be matched to each other. Achieving a good match across several devices is difficult and it significantly complicates the layout. Another disadvantage of the bank of source followers approach is the increase in supply current needed to bias them.

Figure 1 shows an amplifier 101 formed in accordance with one embodiment of the present invention. The amplifier 101 includes input transistors 103a and 103b, a current source 105, load resistors 107a and 107b, and an amplifier stage 109. The gates of the input transistors 103a and 103b are connected to two inputs, Vᵢ₁ and Vᵢ₂. In one embodiment, the transistors are enhancement mode p-channel MOS transistors. The input transistors 103a and 103b are matched physically to have the same dimensions and to be as nearly identical as possible (with an exception detailed below). This ensures that the random offset of the input voltage due to variations in the process and due to strain in the silicon when the die is assembled into the package is less than about 5 millivolts.

The sources of the input transistors 103a and 103b are connected to current source 105. The current source 105 may be, in one embodiment, a load transistor connected to a high voltage rail V_{dd}. The drains of the input transistors 103a and 103b are the inputs to amplification stage 109. The drains of the input transistors 103a and 103b, in one embodiment, may also be connected to low voltage rail Vₛₛ through resistors 107a and 107b. Alternatively, the resistors 107a and 107b may be replaced with load transistors.

Nearly all transistors, including the transistors used in input stages for amplifiers of the prior art, utilize an implant step to adjust their threshold voltages (for turn on) to a standard low value of about 0.7 volts (Vₜₚ in a p-channel transistor). In accordance with one embodiment of the present invention, one of the input transistors 103a or 103b does not have a threshold voltage implant. In Figure 1, it is seen that transistor 103a is indicated (by cross-hatching) as not having the threshold voltage implant.

This will result in a controlled-offset input stage. The voltage threshold implant is blocked from one of the input transistors 103a or 103b, but not the other. The controlled offset voltage of the differential pair is then equal to the threshold adjustment (neglecting the ∼5 milli-volt random variation). The amount of the controlled offset in the amplifier is thus determined by the threshold voltage implant and can be controlled by the process used. Thus, the offset is well-controlled because the pair of input transistors 103a and 103b are designed to be well matched except for the very uniform threshold adjustment applied to one and not the other.

Further, the input controlled-offset of the amplifier or comparator is well-controlled and repeatable across the entire die of the integrated circuit. Moreover, the controlled-offset input stages do not require any additional die area or bias current compared to a normal matched pair input stage.

While the preferred embodiment of the invention has been illustrated and described, it will be appreciated that various changes can be made therein without departing from the spirit and scope of the invention. For example, the controlled-offset amplifier of the present invention may also be used as a comparator.

## Claims

1. A controlled offset amplifier, comprising:
(a) an input stage including two transistors, said two transistors having different threshold voltage implants; and
(b) an amplification stage that receives a signal from said input stage and provides an output signal related to said signal.

2. The amplifier of Claim 1, wherein one of said two transistors does not have a threshold voltage inplant.

3. The amplifier of Claim 2, wherein said input stage comprises two source coupled transistors.

4. The amplifier of Claim 1, wherein said transistors are p-channel MOS transistors.

5. The amplifier of Claim 2, wherein said transistors are p-channel MOS transistors.

6. A method for forming a controlled-offset amplifier comprising:
(a) forming an amplifier stage;
(b) forming an input stage comprised of two input transistors; and
(c) applying a threshold voltage implant to only one of said input transistors.

7. The method of Claim 6, wherein said transistors are p-channel MOS transistors.
